# EUROPEAN PATENT SPECIFICATION

(11) **EP 2 890 828 B1**
(45) Date of publication and mention of the grant of the patent: **14.06.2017**
(21) Application number: 13759886.8
(22) Date of filing: 29.08.2013
(51) Int. Cl.: C23C 16/511, C23C 16/27, C30B 25/10, H01J 37/32, C30B 25/16, C30B 29/04, C23C 16/52

(54) **APPARATUS AND METHOD OF PRODUCING DIAMOND**
VERFAHREN UND VORRICHTUNG ZUR DIAMANTHERSTELLUNG
APPAREIL ET PROCÉDÉ PERMETTANT DE PRODUIRE DU DIAMANT

(30) Priority: 30.08.2012 US 201261695052 P
(43) Date of publication of application: 08.07.2015
(73) Proprietor: IIA Technologies Pte. Ltd., Singapore 049513 (SG)
(72) Inventor: MISRA, Devi Shanker, Singapore 049513 (SG)
(74) Representative: Naylor, Matthew John
(86) International application number: PCT/SG2013/000377
(87) International publication number: WO 2014/035344

(56) References cited:
- JP-A- H0 684 493
- US-A- 5 871 805
- MERMOUX M ET AL: "In situ Raman monitoring of the growth of diamond films in plasma-assisted CVD reactors", DIAMOND AND RELATED MATERIALS, ELSEVIER SCIENCE PUBLISHERS, AMSTERDAM, NL, vol. 4, no. 5-6, May 1995 (1995-05), pages 745-749, XP004066821, ISSN: 0925-9635, DOI: 10.1016/0925-9635(94)05249-2

## Description

### Field of the invention

This invention relates to apparatus and method of producing diamond and performing real time measurements for real time in situ analysis of the diamond growth in situ. In particularly, the invention relates to apparatus and method of producing diamonds by microwave plasma enhanced chemical vapor deposition (MPCVD) and performing real time measurements for analysis of the diamond growth in situ.

### Background

Diamonds, such as single crystal diamonds, have potential for a wide range of scientific, industrial and commercial applications, such as gems, heat dissipation devices, semiconducting devices, optical windows, electromagnetic waveguides, particle detectors, quantum computing devices and so forth. As the commercial demand for single crystal diamonds increase over the years, it is essential to increase the production of optical and scientific grade single crystal diamonds without compromising the quality of the single crystal diamonds. However, defects, inclusions, microscopic grain boundaries, other orientations are prominent defects commonly found in single crystal diamonds which have to be characterized in details.

There exists a number of various chemical vapor deposition (CVD) device and method used to produce single crystal diamonds. For instance, microwave plasma enhanced chemical vapor deposition (MPCVD) method can be used for producing high-quality single crystal diamonds. Currently, the properties of single crystal diamond are characterized by various measuring instruments, such as microscope, spectroscopes and the like, after the completion of diamond growth. The diamond crystal structure and diamond crystal surface property can be measured by analytic techniques, such as X-ray diffraction (XRD), Reflection high-energy electron diffraction (RHEED), and the like. However, this kind of ex situ analysis could only be performed when the grown diamond is removed out from the CVD reaction chamber. Even though these measuring instruments and analytic techniques can identify defects, contaminations and inclusions in the diamonds, it is difficult to remove them in subsequent processes.

In addition, the temperature of the CVD process required for single crystal diamond growth is typically 950°C to 1000°C which leads to excessive heating of the quartz dome. Quartz dome is incapable of efficiently dissipating heat generated in the reaction regime during single crystal diamond growth. Thus, the temperature of the quartz dome has to be monitored at several locations to get an estimate of the average temperature, requiring plurality pyrometers at different locations. Moreover, as only air cooling is provided to the quartz dome in conventional CVD apparatus, the quartz dome cannot be efficiently cooled to control its temperature. High quartz dome temperature could cause O-ring malfunction, which results in contaminated gas leakage into reaction chamber. Ultimately, grown diamond crystal quality could be deteriorated due to the presence of contaminating gases in the reaction chamber.

US Patent No. 6837935 discloses a method of forming a diamond film and a film-forming apparatus. Specifically, it teaches using spectroscope to measure a spectrum of light emitted from plasma discharge. However, it does not suggest any method to perform characterization on diamond growth surface in situ.

There is a need to provide aforementioned analysis and identify the imperfection in the earlier stage. It is an objective of the present invention to provide a device and method of obtaining real-time characterization of the diamond growth surface during production processes without interrupting the production process. More particularly, characterization of the defects can be done real time in situ during diamond growth in the chamber capable of operating CVD process, such that CVD process can be optimized in time to improve the yield of high-quality diamonds.

It is another objective of the present invention to provide a way of cooling reaction regime and accurately controlling reaction chamber temperature.

Other objects and advantages of the present invention will become apparent from the following description, taken in connection with the accompanying drawings, wherein, by wavy of illustration and example, an embodiment of the present invention is disclosed.

JP H06 084493 A discloses a fine structure observation device.
US 5 871 805 A discloses computer controlled vapor deposition processes.
Mermoux et al. [DOI: 10.1016/0925-9635(94)05249-2] discloses in situ Raman monitoring of the growth of diamond films in plasma-assisted CVD reactors.

WO 93/13242 A1 discloses nucleation enhancement for chemical vapor deposition of diamond.

### Summary of the invention

The present invention provides an apparatus as set out in claim 1.

### Brief description of the drawings

The present invention can be more fully understood by a skilled person in the state of the art when reading following detailed description of the preferred embodiments ,with reference made to the accompanying drawings, wherein:
Figure 1 illustrates a schematic of an apparatus for producing diamonds according to a first embodiment of present invention.
Figure 2 illustrates a schematic of an apparatus for producing diamonds according to a second embodiment of present invention.
Figure 3 shows performing the real time in situ analysis during the production of diamonds according to a first embodiment of present invention.
Figure 4 shows the performing of performing real time in situ analysis during the production of diamonds according to other embodiment of present invention.
Figure 5 illustrates a top view of the reaction chamber along dash line A-A in Figure 4.
Figure 6 illustrates a process flow chart for a method of producing diamond and performing real time in situ analysis according to a preferred embodiment of present invention.

### Detailed description

The Figures are diagrammatic and not drawn to scale. In the Figures, elements which correspond to elements already described have the same reference numerals.

In accordance with a first aspect of the present invention, there is provided an apparatus capable of operating chemical vapor deposition for producing diamonds. The apparatus comprises of a housing having a reaction chamber structurally connected to the housing. The reaction chamber comprise of an enclosed space adapted to house the growing of diamonds therein.

A radiating means is mounted above the reaction chamber within the housing. The radiating means is adapted to emit microwave into the reaction chamber to effect the growth of diamonds within the reaction chamber.

The top of the reaction chamber is provided with a dielectric cover adapted to allow radiation wave from the radiating means to enter into the reaction chamber and also to allow the recording means (to be described later) to record the image and video of growing the diamonds within the reaction chamber.

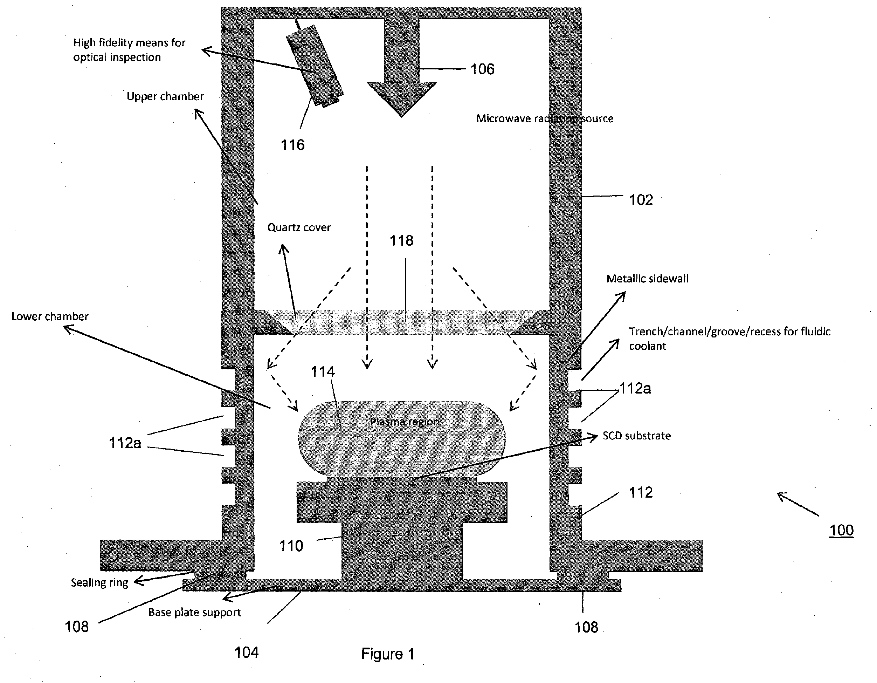

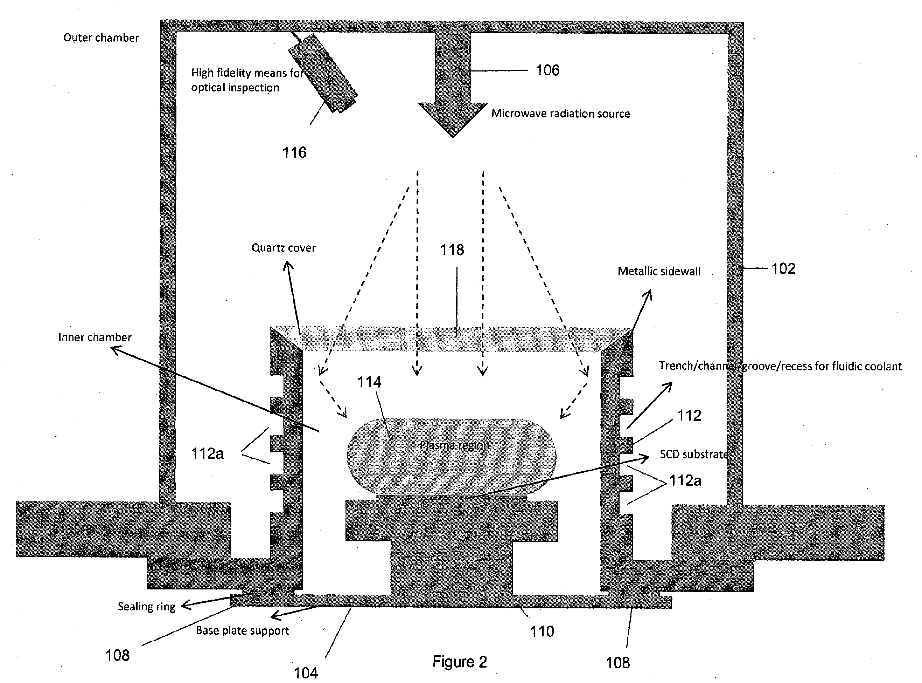

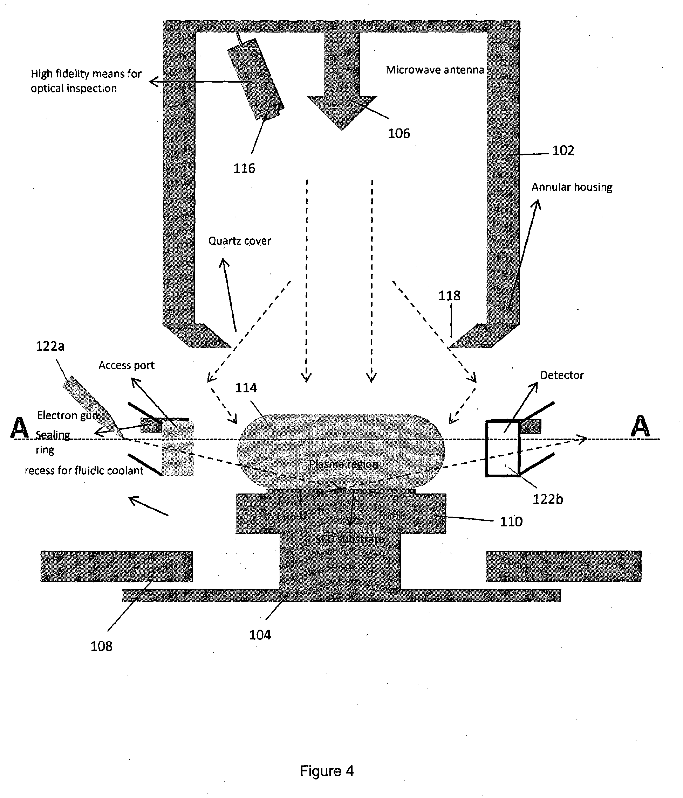

It is submitted that the general description of Figure 1 will suffice to describe the components that are likewise named in Figures 2 to 4.

Figure illustrates a schematic view of an apparatus 100 capable of operating chemical vapor deposition (CVD) process in accordance with a first embodiment of the present invention. The CVD process includes microwave plasma chemical vapor deposition (MPCVD) or any other suitable CVD process. As shown, the apparatus 100 comprises of a housing 102 mounted on top of a reaction chamber 112.

Figure 2 illustrates a schematic view of an apparatus 100 capable of operating chemical vapor deposition (CVD) process in accordance with the second embodiment of the present invention. The CVD process includes microwave plasma chemical vapor deposition (MPCVD) or any other suitable CVD process. As shown, the apparatus 100 comprises of a housing having a reaction chamber 112 mounted within the housing 102.

The housing may in the form of an annular housing 102 having a cylindrical metallic sidewall.

In the first embodiment as shown in Figure 1, the annular housing 102 is mounted on top of the reaction chamber 112. The reaction chamber 112 is also mounted on top of a support in the form of a base plate support 104. The base plate support 104 is coupled to the reaction chamber 112 by means of a sealing ring 108, so that a vacuum environment can be created and maintained within the reaction chamber 112 during the CVD process.

In the second embodiment as shown in Figure 2, the annular housing 102 is mounted on top of a support in the form of a base plate support 104. The reaction chamber 112 is mounted within the housing 102 such that the base plate support 104 is coupled to the reaction chamber 112 by means of a sealing ring 108, so that a vacuum environment can be created and maintained within the reaction chamber 112 during the CVD process.

It is submitted that a vacuum environment is one of the conditions for growing diamonds within the reaction chamber.

The reaction chamber 112 comprise of an enclosed space adapted to house the growth of diamonds therein. The top of the reaction chamber 112 is a dielectric cover in the form of quartz cover 118. The quartz cover 118 is adapted to allow radiation wave from the radiating means 106 to enter into the reaction chamber 112 and also to allow the recording means 116 to record the growth of the diamonds within the reaction chamber 112.

The apparatus 100 includes a radiating means in the form of microwave antenna (also known as microwave radiation source) 106. When in use, the microwave antenna 106 is coupled to the microwave waveguide (not shown) so as to transmit microwave into the reaction chamber 112 to effect the growth of diamonds within the reaction chamber 112. The microwave waveguide is provided and adapted to transmit and direct microwave into the apparatus 100 and at the same time also to prevent the microwave source from incurring damages caused by excessive reverse transmission of microwave. The microwave generator (not shown) includes a magnetizing means in the form of a magnetron is provided to produce a microwave having 6 kilowatt output power at a frequency of 2.45GHz.

In the reaction chamber 112, a substrate stage 110 is mounted concentrically therein and is supported by the base plate support 104. When is use, a plurality of diamond seeds, are disposed on the substrate stage 110 directly or indirectly thereon. In the first and second embodiments, the diamond seeds may be placed directly on the substrate stage 110 for diamond growth. In other embodiment, the diamond may be first placed onto a molybdenum holder before the molybdenum holder is placed onto the substrate stage 110 for diamond growth.

A reaction gas inlet (not shown) is coupled to the reaction chamber 112 so as to supply a mixture of reaction gases into the reaction chamber 112. The mixture of reaction gases is selected from, but not limit to, the group of hydrocarbonaceous gas, hydrogen gas, nitrogen gas, and gases containing other dopants.

When in use, the microwave transmitted by the microwave antenna 106 enters into the reaction chamber 112 by penetrating through the quartz plate 118 and thereafter excites the mixture of reaction gases so as to form a plasma discharge 114. Under a suitable condition, diamond grows on the surface of diamond seeds in the plasma discharge 114 defining a growth surface. As described earlier, one of the conditions is a vacuum environment created and maintained within the reaction chamber 112.

A plurality of recesses 112a is integrally formed on the exterior surface of the cylindrical metallic sidewall of the reaction chamber 112a. In the first and second embodiments, fluidic coolant may be provided to flow continuously in the recesses so as to effectively remove the heat generated inside the reaction chamber 112. The fluidic coolant may be air, nitrogen, inert gas, water or combinations thereof or any other suitable coolants. In other embodiment, the fluidic coolant may be confined in a pipe positioned in the recesses. The fluidic coolant flowing in the recesses can dissipate excessive heat generated by the plasma discharge so as to maintain the temperature in the reaction chamber 112 within a suitable range, within which the sealing rings 108 are functioning effectively to maintain reaction chamber pressure and also to prevent the entrance of contaminating gases into the reaction chamber 112 during diamond growth.

Performing real time in situ analysis during the production of diamonds can be done by providing a recording means, a microscope and a measuring mechanism , which will be described more in detail as follows.

A recording means in the form of high fidelity means 116 is mounted within the annular housing 102 and above the reaction chamber 112 as shown in Figures 1 to 4. The high fidelity means 120 is adapted for optically inspecting the plasma discharge and the diamond growth surface during the diamond growth process. The high fidelity means includes a high fidelity camera 120 mounted at the top of the annular housing 104 so as to capture the top view of the plasma discharge 114 and the diamond growth surface. The high fidelity camera 116 is able to record both images and videos of the diamond growth surface for the purpose of studying the process of diamond growth.

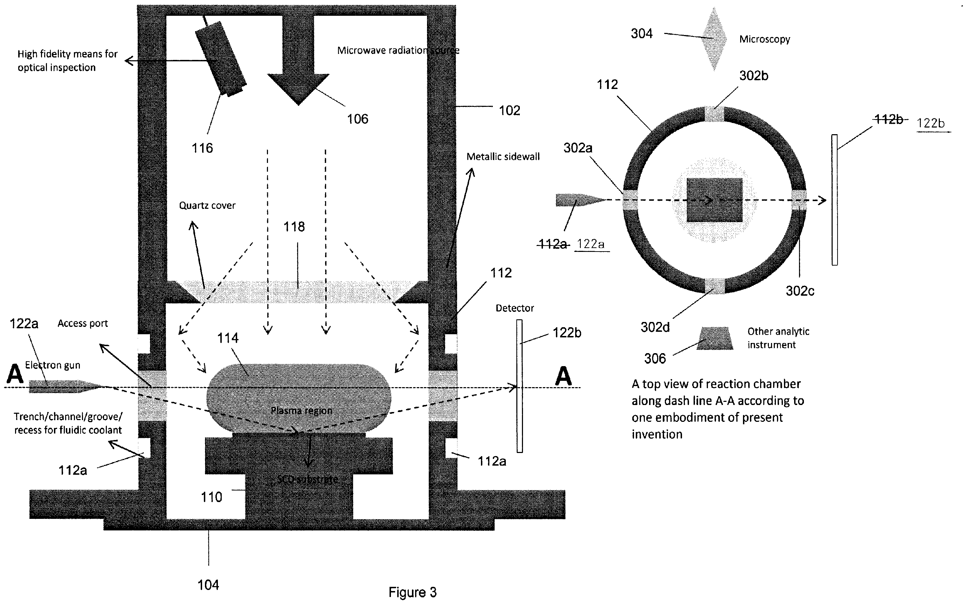

Figure 3 illustrates a schematic view of the measuring mechanism being provided and arranged at the periphery of the reaction chamber 112 in a first embodiment of the present invention.

Figure 3 also illustrates a top view of the reaction chamber 112 being provided with a measuring mechanism along dash line A-A. As shown in Figure 3, a plurality of access ports (302a, 302b, 302c, 302d) is integrally formed on the cylindrical metallic sidewall of the reaction chamber 112.

A measuring mechanism is provided and mounted at the periphery of reaction chamber 112 proximate to the first and third access ports (302a, 302c). The measuring mechanism comprises of a means of emitting analytical beams 122a and a means of receiving the analytical beams 122b.

In a first embodiment of the present invention as shown in Figure 3, the means of emitting analytical beams may be in the form of an electron gun 122a. The electron gun 122a is arranged outside of the first access port 302a to emit electron to strike the diamond growth surface. In other embodiment, the means of emitting analytical beams may be one or more instruments selected from the group of Langmuire probes, long working length microscopy, spectroscopy (photoluminescence spectroscopy, cathodoluminescence spectroscopy, Raman spectroscopy, optical spectroscopy and the like) and reflection high-energy electron diffraction (RHEED).

A means of receiving electron in the form of a detector 112b, for instance ZnS phosphor screen detector, is arranged outside of the third access port 302c that is opposite of the first access port 302a for receiving diffracted electrons.

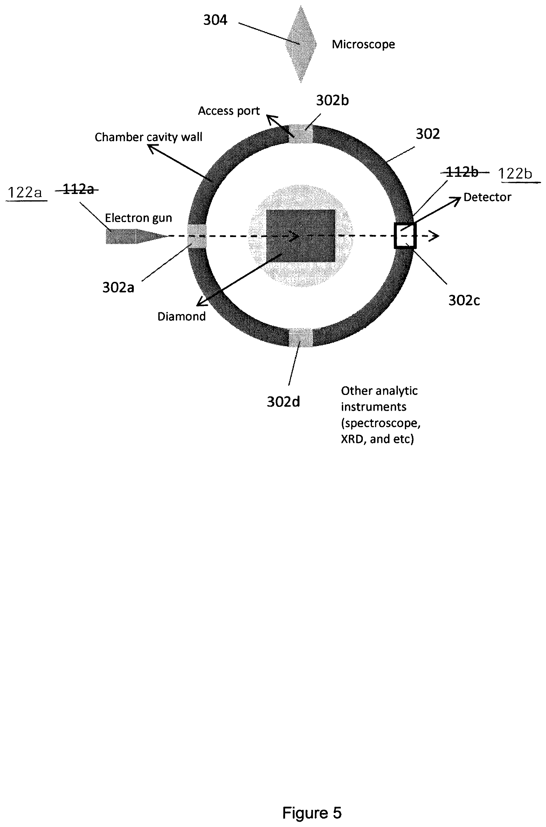

In the first embodiment as shown in Figure 3, the detector 112b is arranged at the outer side of the cylindrical metal side wall of the reaction chamber 112. In the second embodiment as shown in Figure 5, the detector 112b is arranged within the cylindrical metal side wall of the reaction chamber 112.

The measuring mechanism is operable to collect information about the growth surface of the diamond so that real time in situ analysis can be performed while diamond is being grown in the reaction chamber 112 at the same time. It is submitted that a real-time measurement of the diamond growth surface during diamond growth processes can be obtained such that real time in situ analysis can be performed in situ. The real-time characteristics of diamond growth surface are useful in understanding diamond growth mechanism.

Figure 5 also illustrates a top view of the reaction chamber 112 along dash line A-A. A plurality of access ports (302a, 302b, 302c, 302d) can be formed at selected location on cylindrical metal sidewall of the reaction chamber 112. As shown in Figure 5, there are four access ports (302a, 302b, 302c, 302d) formed on the sidewall 302 in the first and second embodiments of the present invention. In other embodiments, any other number of access ports may be formed on the cylindrical metal wall 302 depending on the real time in situ analysis to be performed.

During real time in situ analysis, the electron gun 112a emits a beam of electrons which enter into the reaction chamber 112 via one of the access ports and strike the diamond growth surface at a very small angle relative to the diamond growth surface. Incident electrons diffract from carbon atoms at the diamond growth surface, and a small fraction of the diffracted electrons interfere constructively at specific angles and form regular patterns on the detector. The electrons interfere according to the position of atoms on the diamond growth surface, so the diffraction pattern at the detector is a function of the diamond growth surface.

As shown in Figure 3, a microscope in the form of a long working length microscope 304 is provided and adjacently arranged at the outside of second access port 302b in the first embodiment of the present invention. The microscope 304 is used to observe the plasma discharge 114 and collect the images of the diamond growth surface.

Other analytic instruments 306 may be adjacently arranged at the outside of the a fourth access port 302d that is opposite of the second access port 302b. The analytical instrument includes Raman spectroscope and XRD for measuring the purity of the grown diamond layer through the fourth access port 302d and obtain Raman spectrum based on measurement results.

In another embodiment of the present invention, a means for adjusting the position of the growth surfaces of the diamond seeds along axis of the annular housing 104 is provided tin the substrate stage 110. The means of adjustment (not shown) may be an actuator, a step motor and the like. The means of adjustment is used to maintain the growth surfaces of the diamond seeds at a position, where the electron beam from the electron gun 112a can always strike on the diamond growth surface throughout the whole diamond synthetic process. After diamond growth for a specific time interval, certain thickness, x um, of diamond has been grown. The means of adjustment brings the growth surfaces downwards along axis of the annular housing 104 for the same x um such that electron beam can strike on the growth surfaces without any adjustment to itself. It has been unexpectedly discovered that a more accurate real time in situ analysis result can be obtained with the aforementioned method.

In accordance with a second aspect of the present invention, it provides a method of producing diamond and performing real time in situ analysis thereof.

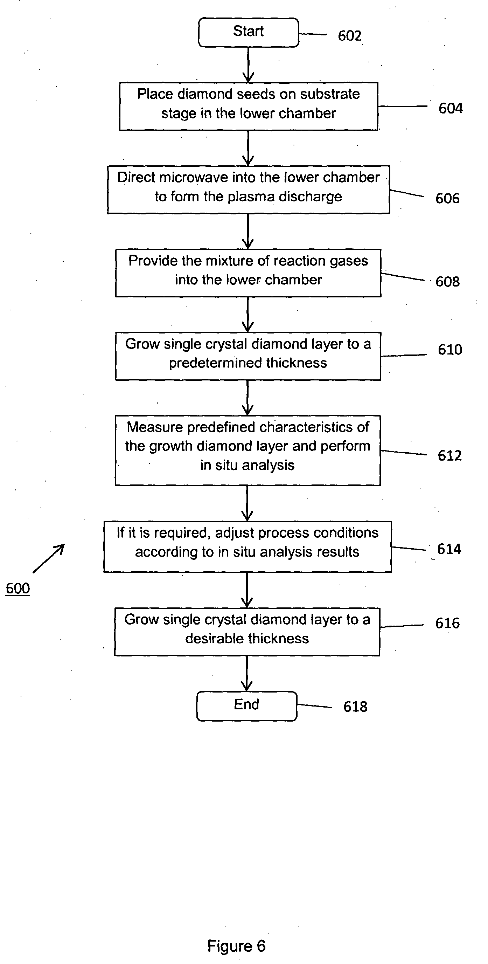

A process flow chart 600 is shown in Figure 6 in accordance with a preferred embodiment of the present invention.

The process starts at step 602.

At step 604, a plurality of diamond seeds are disposed inside the reaction chamber 112. In the first embodiment of the present invention, the plurality of diamond seeds are disposed on a substrate stage in-the reaction chamber 112. In other embodiment, diamond seeds may be disposed onto a molybdenum substrate holder first before the molybdenum substrate holder is placed on the substrate stage 110.

After that, at step 606, hydrogen gas is supplied into the reaction chamber 112 and microwave emitted from the microwave radiation source 106 is directed thereto to form plasma discharge 114 so as to treat the top surface of diamond seeds.

At step 608, the mixture of reaction gases is supplied into the reaction chamber 112, wherein the mixture of reaction gases may comprise hydrocarbonaceous gas, hydrogen gas, nitrogen gas, and gases containing other dopants.

At step 610, after a predetermined thickness diamond layer is grown on the diamond seeds in the plasma discharge, a set of predefined characteristics of the growth diamond layer are measured and real time in situ analysis is performed based on the measurement results in step 612.

If it is required, process conditions are adjusted according to in situ analysis results at step 614.

Growth of diamond layer continues until a desirable thickness is achieved at step 616.

The process ends at step 618.

It is apparent to a person skilled in the art that many modifications, alternatives and variations may be made to the preferred embodiment of the present invention as described above without departing from the scope of the present invention. Accordingly, it is intended to embrace all such modifications, alternatives and variations that fall within the scope of the included claims.

## Claims

1. An apparatus for producing diamond and performing real time in situ analysis, comprising:
a housing (102),
a reaction chamber (112), the reaction chamber (112) being structurally connected to the housing (102), the reaction chamber (112) comprising of an enclosed area adapted to house the growing of diamonds,
a radiating means (106), the radiating means (106) being mounted above the reaction chamber (112) within the housing (102), the radiating means (106) adapted to emit microwave into the reaction chamber (112) to effect the growth of diamonds within the reaction chamber (112),
a recording means (116) mounted above the reaction chamber (112),
a dielectric cover (118) being provided on top of the reaction chamber (112) and arranged in between the enclosed area and both of the radiating means (106) and recording means (116) and is adapted to allow the radiation wave from the radiating means (106) to enter the reaction chamber (112) and also to allow the recording means (116) to record the growth of the diamonds within the reaction chamber (112),
**characterized in that**:
the recording means (116) is mounted within the housing (102).

2. The apparatus according to claim 1, further comprising:
a measuring mechanism arranged at the periphery of the reaction chamber (112) proximate to first and third access ports (302a, 302c), the measuring mechanism comprising of a means of emitting analytical beams in the form of electron gun (112a) and a means of receiving analytical beams (112b),
a microscope (304) is adjacently placed on the outside of a second access port (302b) of the reaction chamber.

3. The apparatus according to any one of claims 1 or 2, wherein the housing (102) is mounted on top of the reaction chamber (112), the reaction chamber (112) is mounted on top of a support (104) which is in the form of base plate support, the support (104) is coupled to the reaction chamber (112) by means of a sealing ring (108).

4. The apparatus according to any one of claims 1 or 2, wherein the reaction chamber (112) is mounted within the housing (102) which is mounted on top of a support (104), the support (104) is coupled to the reaction chamber by means of a sealing ring (108).

5. The apparatus according to any one of the preceding claims, wherein the dielectric cover (118) is in the form of quartz cover.

6. The apparatus according to any one of the preceding claims, wherein the radiating means (106) is in the form of microwave antenna.

7. The apparatus according to any one of the preceding claims, wherein the reaction chamber is provided with a substrate stage (110) mounted concentrically herein, the substrate stage (110) is supported by the support (104).

8. The apparatus according to any one of claims 2 to 7, wherein reaction chamber (112) comprise of cylindrical metallic sidewall, a plurality of recesses (112a) being integrally formed on the exterior surface of the cylindrical metallic sidewall, and four access ports (302a, 302b, 302c, 302d) are formed at selected location on the cylindrical metallic sidewall.

9. The apparatus according to any one of the preceding claims, wherein the housing (102) is in the form of annular housing having a cylindrical metallic sidewall.

10. The apparatus according to any one of the preceding claims, wherein the recording means (116) is in the form of high fidelity camera.

11. The apparatus according to any one of claims 2 to 10, further comprising an analytic instrument (306) adjacently arranged at the outside of the fourth access port (302d) of the apparatus, the analytical instrument (206) includes Raman spectroscope and XRD.

12. The apparatus according to any one of claims 7 to 20, wherein the substrate stage (110) further comprising of an adjusting means for adjusting the position of the growth surfaces of the diamond seeds along axis of the annular housing, whereby the adjustment means may in the form of actuator, step motor and the like.

13. A method of producing diamond and performing real time in situ analysis, comprising:
providing an apparatus according to claims 1 to 12,
placing a plurality of diamond seeds inside the reaction chamber (112),
supplying hydrogen gas into the reaction chamber (112),
directing microwave emitted from the radiating means via the dielectric cover into the reaction chamber (112) to form plasma discharge,
supplying mixture of reaction gases into the reaction chamber (112),
growing the diamonds to a predetermined thickness,
recording the growth of the diamonds within the reaction chamber by the recording means (116) via the dielectric cover (118),
measuring a set of predefined characteristics of the growth diamond layer,
performing real time in situ analysis based on the measurement result,
adjusting the process conditions according to the in situ analysis result,
growing the diamond until a desirable thickness is achieved.

14. The method according to claim 13, wherein the plurality of diamond seeds is placed on a substrate in the reaction chamber (112).

15. The method according to claim 13, wherein the plurality of diamond seeds is placed onto a molybdenum substrate holder first before the molybdenum substrate holder is placed on the substrate stage (110).

## Patentansprüche

1. Vorrichtung zur Herstellung von Diamanten und zur Ausführung einer Echtzeit-In-situ-Analyse, umfassend:
ein Gehäuse (102),
eine Reaktionskammer (112), wobei die Reaktionskammer (112) mit dem Gehäuse (102) strukturell verbunden ist, wobei die Reaktionskammer (112) einen eingeschlossenen Bereich umfasst, der geeignet ist, das Züchten von Diamanten aufzunehmen,
ein Abstrahlungsmittel (106), wobei das Abstrahlungsmittel (106) oberhalb der Reaktionskammer (112) innerhalb des Gehäuses (102) angebracht ist, wobei das Abstrahlungsmittel (106) geeignet ist, eine Mikrowelle in die Reaktionskammer (112) hinein zu emittieren, um das Wachstum von Diamanten innerhalb der Reaktionskammer (112) zu bewirken,
ein Aufzeichnungsmittel (116), das oberhalb der Reaktionskammer (112) angebracht ist,
eine dielektrische Abdeckung (118), die auf der Oberseite der Reaktionskammer (112) vorgesehen und zwischen dem eingeschlossenen Bereich und sowohl dem Abstrahlungsmittel (106) als auch dem Aufzeichnungsmittel (116) angeordnet ist, und geeignet ist, es der Mikrowelle aus dem Abstrahlungsmittel (106) zu ermöglichen, in die Reaktionskammer (112) einzutreten, und es dem Aufzeichnungsmittel ferner zu ermöglichen, das Wachstum der Diamanten innerhalb der Reaktionskammer (112) aufzuzeichnen,
**dadurch gekennzeichnet, dass**:
das Aufzeichnungsmittel (116) innerhalb des Gehäuses (102) angebracht ist.

2. Vorrichtung gemäß Anspruch 1, ferner umfassend:
einen Messmechanismus, der am Randbereich der Reaktionskammer (112) nahe einer ersten und einer dritten Zugangsöffnung (302a, 302c) angeordnet ist, wobei der Messmechanismus ein Mittel zum Emittieren von analytischen Strahlen in Form einer Elektronenkanone (112a) und ein Mittel zum Aufnehmen von analytischen Strahlen (112b) umfasst,
wobei ein Mikroskop (304) auf der Außenseite einer zweiten Zugangsöffnung (302b) der Reaktionskammer angrenzend platziert ist.

3. Vorrichtung gemäß einem der Ansprüche 1 oder 2, worin das Gehäuse (102) auf der Oberseite der Reaktionskammer (112) angebracht ist, worin die Reaktionskammer (112) auf der Oberseite eines Stützelements (104) angebracht ist, das in der Form eines Basisplattenstützelements ist, wobei das Stützelement (104) mit der Reaktionskammer (112) mittels eines Dichtrings (108) gekoppelt ist.

4. Vorrichtung gemäß einem der Ansprüche 1 oder 2, worin die Reaktionskammer (112) innerhalb des Gehäuses (102) angebracht ist, das auf der Oberseite eines Stützelements (104) angebracht ist, wobei das Stützelement (104) mit der Reaktionskammer mittels eines Dichtrings (108) gekoppelt ist.

5. Vorrichtung gemäß einem der vorangegangenen Ansprüche, worin die dielektrische Abdeckung (118) in Form einer Quarz-Abdeckung ist.

6. Vorrichtung gemäß einem der vorangegangenen Ansprüche, worin das Abstrahlungsmittel (106) in Form einer Mikrowellenantenne ist.

7. Vorrichtung gemäß einem der vorangegangenen Ansprüche, worin die Reaktionskammer mit einer Substratstufe (110) versehen ist, die konzentrisch darin angebracht ist, wobei die Substratstufe (110) durch das Stützelement (104) gelagert wird.

8. Vorrichtung gemäß einem der Ansprüche 2 bis 7, worin die Reaktionskammer (112) eine zylindrische metallene Seitenwand umfasst, wobei eine Vielzahl von Aussparungen (112a) auf der äußeren Oberfläche der zylindrischen metallenen Seitenwand einstückig ausgebildet ist, und vier Zugangsöffnungen (203a, 302b, 302c, 302d) an ausgewählter Stelle auf der zylindrischen metallenen Seitenwand ausgebildet sind.

9. Vorrichtung gemäß einem der vorangegangenen Ansprüche, worin das Gehäuse (102) in Form eines ringförmigen Gehäuses ist, das eine zylindrische metallene Seitenwand aufweist.

10. Vorrichtung gemäß einem der vorangegangenen Ansprüche, worin das Aufzeichnungsmittel (116) in Form einer Kamera mit hoher Wiedergabetreue ist.

11. Vorrichtung gemäß einem der Ansprüche 2 bis 10, ferner umfassend ein analytisches Instrument (306), das an der Außenseite der vierten Zugangsöffnung (302d) der Vorrichtung angrenzend angebracht ist, wobei das analytische Instrument (206) ein Raman-Spektroskop und eine Röntgendiffraktometrie-Vorrichtung umfasst.

12. Vorrichtung gemäß einem der Ansprüche 7 bis 20, worin die Substratstufe (110) ferner ein Einstellungsmittel für das Einstellen der Position der Wachstumsoberflächen der Diamantenkristallkeime entlang der Achse des ringförmigen Gehäuses umfasst, wodurch das Einstellungsmittel in der Form eines Aktuators, eines Schrittmotors und von ähnlichem sein kann.

13. Verfahren zur Herstellung von Diamanten und zur Ausführung einer Echtzeit-In-situ-Analyse, umfassend:
Bereitstellen einer Vorrichtung gemäß den Ansprüchen 1 bis 12,
Platzieren einer Vielzahl von Diamantenkristallkeimen im Inneren der Reaktionskammer (112),
Versorgen der Reaktionskammer (112) mit Wasserstoffgas,
Führen der aus dem Abstrahlungsmittel emittierten Mikrowelle über die dielektrische Abdeckung in die Reaktionskammer (112) hinein, um eine Plasmaentladung zu bilden,
Versorgen der Reaktionskammer (112) mit einem Gemisch aus Reaktionsgasen,
Wachsen-Lassen der Diamanten auf eine vorbestimmte Dicke,
Aufzeichnen des Diamantenwachstums innerhalb der Reaktionskammer durch das Aufzeichnungsmittel (116) über die dielektrische Abdeckung (118),
Messen eines Satzes von vorbestimmten Charakteristika der Diamantenwachstumsschicht,
Ausführen einer Echtzeit-In-situ-Analyse auf Basis des Messergebnisses,
Einstellen der Verfahrensbedingungen gemäß dem In-situ-Analyse-Ergebnis,
Wachsen-Lassen des Diamanten auf eine Soll-Dicke.

14. Verfahren gemäß Anspruch 13, worin die Vielzahl von Diamantenkristallkeimen auf einem Substrat in der Reaktionskammer (112) platziert ist.

15. Verfahren gemäß Anspruch 13, worin die Vielzahl von Diamantenkristallkeimen zuerst auf einem Molybdänsubstrathalter platziert wird, bevor der Molybdänsubstrathalter auf der Substratstufe (110) platziert wird.

## Revendications

1. Appareil de production de diamants et de réalisation d'une analyse in situ en temps réel, comprenant :
un boîtier (102),
une chambre de réaction (112), la chambre de réaction (112) étant reliée structurellement au boîtier (102), la chambre de réaction (112) comprenant une zone fermée adaptée pour recevoir la croissance de diamants,
des moyens de rayonnement (106), les moyens de rayonnement (106) étant montés au-dessus de la chambre de réaction (112) à l'intérieur du boîtier (102), les moyens de rayonnement (106) étant adaptés pour émettre des micro-ondes dans la chambre de réaction (112) pour réaliser la croissance de diamants à l'intérieur de la chambre de réaction (112),
des moyens d'enregistrement (116) montés au-dessus de la chambre de réaction (112),
un couvercle diélectrique (118) agencé sur le dessus de la chambre de réaction (112) et disposé entre la zone fermée et à la fois les moyens de rayonnement (106) et les moyens d'enregistrement (116), et qui est adapté pour permettre aux ondes de rayonnement provenant des moyens du rayonnement (106) d'entrer dans la chambre de réaction (112) et également pour permettre aux moyens d'enregistrement (116) d'enregistrer la croissance des diamants à l'intérieur de la chambre de réaction (112),
**caractérisé en ce que** :
les moyens d'enregistrement (116) sont montés à l'intérieur du boîtier (102).

2. Appareil selon la revendication 1, comprenant en outre :
un mécanisme de mesure disposé à la périphérie de la chambre de réaction (112) à proximité des premier et troisième orifices d'accès (302a, 302c), le mécanisme de mesure comprenant des moyens d'émission de faisceaux analytiques sous la forme de canon à électrons (112a) et des moyen de réception de faisceaux analytiques (112b),
un microscope (304) étant placé de manière adjacente à l'extérieur d'un deuxième orifice d'accès (302b) de la chambre de réaction.

3. Appareil selon l'une quelconque des revendications 1 ou 2, dans lequel le boîtier (102) est monté sur le dessus de la chambre de réaction (112), la chambre de réaction (112) est montée sur un support (104) qui est en forme de support de plaque de base, et le support (104) est couplé à la chambre de réaction (112) au moyen d'une bague d'étanchéité (108).

4. Appareil selon l'une quelconque des revendications 1 ou 2, dans lequel la chambre de réaction (112) est montée à l'intérieur du boîtier (102) qui est monté sur le dessus d'un support (104), et le support (104) est couplé à la chambre de réaction par l'intermédiaire d'une bague d'étanchéité (108).

5. Appareil selon l'une quelconque des revendications précédentes, dans lequel le couvercle diélectrique (118) se présente sous la forme d'un couvercle en quartz.

6. Appareil selon l'une quelconque des revendications précédentes, dans lequel les moyens de rayonnement (106) se présentent sous la forme d'une antenne hyperfréquence.

7. Appareil selon l'une quelconque des revendications précédentes, dans lequel la chambre de réaction est munie d'un étage de substrat (110) qui y est monté concentriquement, et l'étage de substrat (110) est supporté par le support (104).

8. Appareil selon l'une quelconque des revendications 2 à 7, dans lequel la chambre de réaction (112) comprend une paroi latérale métallique cylindrique, une pluralité d'évidements (112a) étant formés d'une seule pièce sur la surface extérieure de la paroi latérale cylindrique métallique, et quatre orifices d'accès (302a, 302b, 302c, 302d) sont formées à un endroit choisi sur la paroi latérale cylindrique métallique.

9. Appareil selon l'une quelconque des revendications précédentes, dans lequel le boîtier (102) se présente sous la forme d'un boîtier annulaire comportant une paroi latérale cylindrique métallique.

10. Appareil selon l'une quelconque des revendications précédentes, dans lequel les moyens d'enregistrement (116) se présentent sous la forme d'une caméra haute fidélité.

11. Appareil selon l'une quelconque des revendications 2 à 10, comprenant en outre un instrument analytique (306) agencé de manière adjacente à l'extérieur du quatrième orifice d'accès (302d) de l'appareil, l'instrument analytique (206) comprenant un spectroscope Raman et XRD.

12. Appareil selon l'une quelconque des revendications 7 à 20, dans lequel l'étage de substrat (110) comprend en outre des moyen d'ajustement pour ajuster la position des surfaces de croissance des graines de diamant le long de l'axe du boîtier annulaire, de sorte que les moyens d'ajustement peuvent avoir la forme d'un actionneur, d'un moteur pas-à-pas et analogue.

13. Procédé de production de diamants et de réalisation d'une analyse in situ en temps réel, comprenant les étapes consistant à :
fournir un appareil selon les revendications 1 à 12,
placer une pluralité de graines de diamant à l'intérieur de la chambre de réaction (112),
alimenter de l'hydrogène gazeux jusque dans la chambre de réaction (112),
diriger des micro-ondes émises depuis les moyens de rayonnement via le couvercle diélectrique jusque dans la chambre de réaction (112) pour former une décharge de plasma,
alimenter un mélange de gaz de réaction jusque dans la chambre de réaction (112),
faire croître les diamants à une épaisseur prédéterminée,
enregistrer la croissance des diamants à l'intérieur de la chambre de réaction par l'intermédiaire des moyens d'enregistrement (116) via le couvercle diélectrique (118),
mesurer un ensemble de caractéristiques prédéfinies de la couche de diamant de croissance,
effectuer une analyse in situ en temps réel sur la base du résultat de mesure,
ajuster les conditions de processus en fonction du résultat de l'analyse in situ,
faire croître le diamant jusqu'à l'obtention d'une épaisseur souhaitable.

14. Procédé selon la revendication 13, dans lequel la pluralité de graines de diamant est placée sur un substrat dans la chambre de réaction (112).

15. Procédé selon la revendication 13, dans lequel la pluralité de graines de diamant est placée sur un support de substrat de molybdène en premier avant que le support de substrat de molybdène ne soit placé sur l'étage de substrat (110).
